(19) 

**Europäisches Patentamt**

**European Patent Office**

**Office européen des brevets**

(11) **EP 4 560 875 A1**

(12) **EUROPEAN PATENT APPLICATION**

(43) Date of publication:
**28.05.2025 Bulletin 2025/22**

(21) Application number: **24180340.2**

(22) Date of filing: **05.06.2024**

(51) International Patent Classification (IPC):
*H02J 7/00* *(2006.01)*

(52) Cooperative Patent Classification (CPC):
**H02J 7/00714; H02J 7/007194**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **22.11.2023 TW 112145149**

(71) Applicant: **Quanta  Computer Inc.
Taoyuan City 333 (TW)**

(72) Inventor: **YEN, Wei-Ting
333 Taoyuan City (TW)**

(74) Representative: **Michalski Hüttermann & Partner
Patentanwälte mbB
Kaistraße 16A
40221 Düsseldorf (DE)**

(54) **METHOD AND DEVICE FOR ARTIFICIAL INTELLIGENCE MONITORING AND PROTECTING BATTERY PERFORMANCE**

(57)    A method for artificial intelligence monitoring and protecting battery performance is provided. The method includes determining whether a temperature and a current of a battery cell of a battery pack are within a limit specification. The method includes obtaining a maximum current power when the temperature and the current of the battery pack are within the limit specification. The method includes performing an operation based on the maximum current power.

**EP 4 560 875 A1**

## Description

## BACKGROUND OF THE APPLICATION

## Field of the Application

The present disclosure generally relates to the field of battery technologies. More specifically, aspects of the present disclosure relate to a method and device for artificial intelligence monitoring and protecting battery performance.

## Description of the Related Art

Today's society has increasingly higher requirements for energy conservation and environmental protection, and optimizing battery energy efficiency is one of the keys to achieving energy conservation and environmental protection. With the continuous advancements being made in battery-related technologies, the application of battery management systems (BMS) is becoming more and more widespread.

Battery management systems usually have the function of measuring battery voltage to prevent abnormal conditions from developing, such as battery over-discharging, over-charging, and overheating. General battery management systems usually use protection mechanisms such as over current protection (OCP) and over temperature protection (OTP) to manage batteries. However, these protection mechanisms all use fixed thresholds to protect the battery from current and over-temperature, but they cannot optimize the battery's energy efficiency.

Therefore, there is a need for a method and device for artificial intelligence monitoring and protecting battery performance, which can optimize battery energy efficiency, and ensure the normal operation of the battery, and extend battery life.

## SUMMARY

The following summary is illustrative only and is not intended to be limiting in any way. That is, the following summary is provided to introduce concepts, highlights, benefits and advantages of the novel and non-obvious techniques described herein. Select, not all, implementations are described further in the detailed description below. Thus, the following summary is not intended to identify essential features of the claimed subject matter, nor is it intended for use in determining the scope of the claimed subject matter.

Therefore, a method and device for artificial intelligence monitoring and protecting battery performance provided in the present disclosure uses a maximum current power to optimize battery energy efficiency, ensure normal operation of the battery, and extend the life of the battery pack.

In an exemplary embodiment, a method for artificial intelligence monitoring and protecting battery performance is provided. The method includes determining whether a temperature and a current of a battery cell of a battery pack are within a limit specification. The method includes obtaining a maximum current power when the temperature and the current of the battery pack are within the limit specification. The method includes performing an operation based on the maximum current power.

In some embodiments, the maximum current power is obtained based on a relative state of charge (RSOC), a voltage, a system impedance value, an optimization parameter, and a battery impedance value of the battery pack.

In some embodiments, the maximum current power is expressed by the following formula:

$$MCP = \frac{D}{(E + F + G)} \times B$$

wherein $B$ is the RSOC, $D$ is the voltage, E is the system impedance value, F is the optimization parameter and G is the battery impedance value.

In some embodiments, the optimization parameter is generated by a large language model (LLM) or a large data model.

In some embodiments, the step of determining whether the temperature and the current of the battery cell of the battery pack are within the limit specification further comprises determining whether the temperature of the battery cell is within an operating temperature range, whether the current is within an over-current protection (OCP) operating limit and is within a short-circuit protection operating limit.

In some embodiments, the step of performing the operation based on the maximum current power further comprises transmitting a notification message to a processor to notify the processor of a power condition that the battery cell currently supports when an indicator corresponding to the maximum current power is lower than a threshold.

In some embodiments, the step of performing the operation based on the maximum current power further comprises transmitting a notification message to a processor to notify the processor of a power condition that the battery cell currently supports when an indicator corresponding to the maximum current power is lower than a threshold.

In an exemplary embodiment, a device for artificial intelligence monitoring and protecting battery performance is provided. The device comprises a battery pack comprising a battery cell and a controller. The controller is operative to determine whether a temperature and a current of a battery cell of a battery pack are within a limit specification, obtain a maximum current power when the temperature and the current of the battery pack are within the limit specification, and perform an operation based on the maximum current power.

## BRIEF DESCRIPTION OF DRAWINGS

The accompanying drawings are included to provide a further understanding of the present disclosure, and are incorporated in and constitute a part of the present disclosure. The drawings illustrate implementations of the disclosure and, together with the description, serve to explain the principles of the disclosure. It should be appreciated that the drawings are not necessarily to scale as some components may be shown out of proportion to their size in actual implementation in order to clearly illustrate the concept of the present disclosure.

FIG. 1 is a schematic diagram of a system for artificial intelligence monitoring and protecting battery performance according to an embodiment of the present disclosure.

FIG. 2 is a diagram illustrating the internal structure of the battery pack according to an embodiment of the present disclosure.

FIG. 3 is a flow chart of a method for artificial intelligence monitoring and protecting battery performance according to an embodiment of the present disclosure.

FIG. 4 shows an experimental data table for obtaining the maximum current power and the state indicator according to an embodiment of the present disclosure.

FIG. 5 is a schematic diagram showing the discharge of the battery pack according to an embodiment of the present disclosure with reference to FIG. 4.

FIG. 6 is a schematic diagram illustrating the relationship between the MCP and the RSOC according to an embodiment of the present disclosure.

FIG. 7 is a schematic diagram illustrating the relationship between the MCP and the time according to an embodiment of the present disclosure.

## DETAILED DESCRIPTION

Various aspects of the disclosure are described more fully below with reference to the accompanying drawings. This disclosure may, however, be embodied in many different forms and should not be construed as limited to any specific structure or function presented throughout this disclosure. Rather, these aspects are provided so that this disclosure will be thorough and complete, and will fully convey the scope of the disclosure to those skilled in the art. Based on the teachings herein one skilled in the art should appreciate that the scope of the disclosure is intended to cover any aspect of the disclosure disclosed herein, whether implemented independently of or combined with any other aspect of the disclosure. For example, an apparatus may be implemented, or a method may be practiced using number of the aspects set forth herein. In addition, the scope of the disclosure is intended to cover such an apparatus or method which is practiced using another structure, functionality, or structure and functionality in addition to or other than the various aspects of the disclosure set forth herein. It should be understood that any aspect of the disclosure disclosed herein may be embodied by one or more elements of a claim.

The word "exemplary" is used herein to mean "serving as an example, instance, or illustration." Any aspect described herein as "exemplary" is not necessarily to be construed as preferred or advantageous over other aspects. Furthermore, like numerals refer to like elements throughout the several views, and the articles "a" and "the" includes plural references, unless otherwise specified in the description.

It should be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion. (e.g., "between" versus "directly between", "adjacent" versus "directly adjacent", etc.).

The embodiments of the present disclosure provide a method and device for artificial intelligence monitoring and protecting battery performance provided in the present disclosure, which uses a maximum current power to optimize battery energy efficiency, ensure normal operation of the battery, and extend the life of the battery pack.

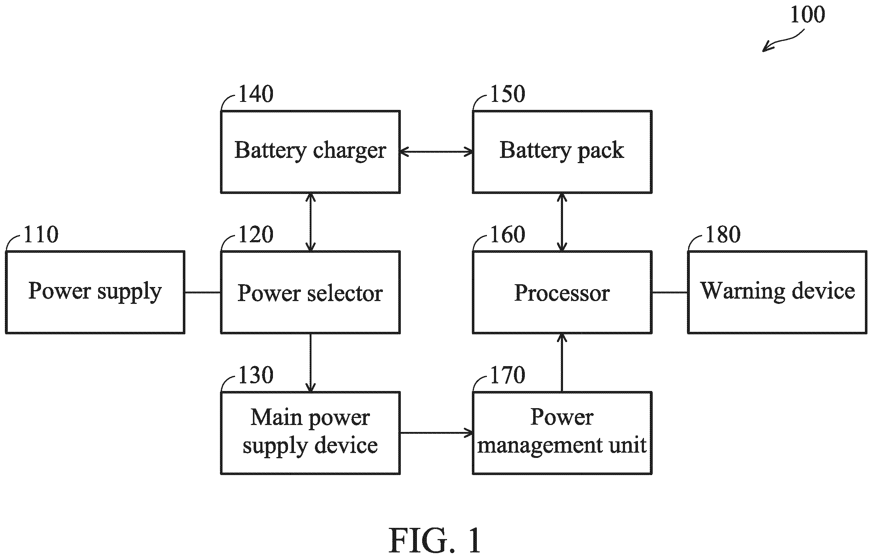

FIG. 1 is a schematic diagram of a system 100 for artificial intelligence monitoring and protecting battery performance according to an embodiment of the present disclosure. The system 100 comprises a power supply 110, a power selector 120, a main power device 130, a battery charger 140, a battery pack 150, a processor 160, a power management unit 170 and a warning device 180.

The power supply 110 may be an adapter or an universal serial bus (USB). The power selector 120 is coupled to the power supply 110, the main power device 130 and the battery charger 140. The power selector 120 selects DC/AC as the main power source when DC/AC is available. Otherwise, the power selector 120 selects the battery as the power source.

The main power supply device 130 can be a system terminal, for example, any type of device such as 3C products, notebook computers, tablet computers, robots, and car batteries. The battery charger 140 is coupled to the power selector 120 and the battery pack 150 and has a charge/discharge circuit. The battery pack 150 may comprise battery packs in various combinations, such as single series connection, multiple series connection, single parallel connection, multiple parallel connection, and other combinations.

The processor 160 is coupled to the battery pack 150, the power management unit 170 and the warning device 180. The processor 160 may be any processor suitable for executing instructions, such as instructions from memory (not shown). Accordingly, the processor 160 may be, for example, a central processing unit (CPU), a microprocessor, or other similar processor.

The power management unit 170 is coupled to the main power device 130 and the processor 160 and may provide basic power protection for the system 100.

The warning device 180 may be a display, LED, or other output component with a warning function.

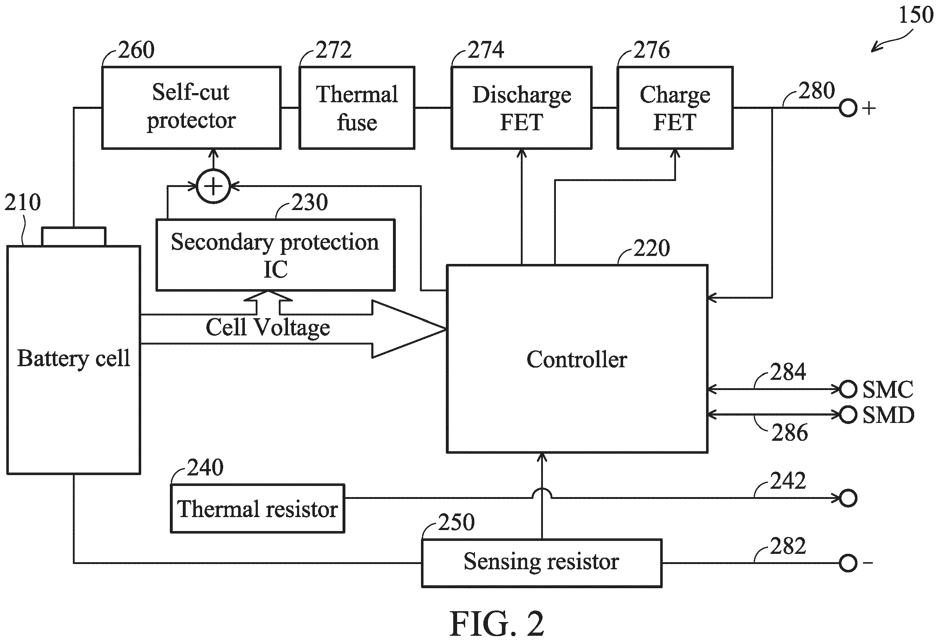

FIG. 2 is a diagram illustrating the internal structure of the battery pack 150 according to an embodiment of the present disclosure. The battery pack 150 may comprise, but is not limited to, a battery cell 210, a controller 220, a secondary protection IC 230, a thermal resistor 240, a sensing resistor 250, a self-cut protector 260, a thermal fuse 272, and a discharge field-effect transistor (FET) 274, a charge field-effect transistor 276.

The controller 220 may be a general processor, a micro control unit (MCU), an application processor, etc., which comprises various circuits for providing data processing and computing functions and controls the battery cell 210 to communicate with the microprocessor 160 and the battery charger 140 in FIG. 1.

The controller 220 is coupled to the battery cell 210, the secondary protection IC 230, the thermal resistor 240 and the sensing resistor 250. The controller 220 may support a wide range of first-level and second-level battery safety features. The first-level safety features include: cell-level overvoltage/undervoltage protection, charge/discharge overcurrent protection, short circuit protection and overtemperature protection. The second-level safety feature is used to indicate more serious faults and can cause an in-line fuse (e.g., thermal fuse 272) to be blown to permanently disable the battery cell 210. The second-level safety features include: safety overvoltage, battery cell imbalance, safety overcurrent, safety overtemperature, open thermister 240, charge and discharge FET 276 faults, fuse blow failure detection, etc.

In addition, the controller 220 and the secondary protection IC 230 may also trigger the self-cut protector 260 coupled to the battery cell 210 to activate the protection mechanism of the battery cell 210. The controller 220 may obtain the temperature 242 of the battery cell 210 through the thermal resistor 240 and obtain the current of the battery cell 210 through the sensing resistor 250. The controller 220 may instantly track the capacity changes, battery impedance, voltage, current, temperature and other key operating parameters of the battery cell 210 and obtain a maximum current power. In one embodiment, the controller 220 may generate certain control signals based on the maximum current power to initiate appropriate safety precautions for the battery cell 210.

In FIG. 2, the battery pack 150 has a positive terminal 280 and a negative terminal 282 for connection to the battery charger 140 for charging. The controller 220 uses the Smart Battery Bus (SMBus) protocol to communicate with the processor 160 in FIG. 1. The SMBus consists of data line SMD 284 and clock line SMC 286, via which the controller 220, and the processor 160 communicate with each other.

In another embodiment, the battery pack 150 may include a memory (not shown) that may store instructions associated with the operation of the battery pack 150, wherein the instructions are executed by the controller 220. The controller 220 may also execute programs and instructions in the memory to perform the actions and steps described in the embodiments of the present disclosure, or other descriptions in the specification.

In another embodiment, the controller 220 may implement a large language model (LLM) or a big data model based on a neural network and use the large language model or big data model to realize the generation of relevant parameters of the battery pack.

It should be noted that although the number of battery cells 210 is one battery as an example in FIG. 2, the battery cells can be expanded to other combinations (for example, two in series, two in series and one in parallel, etc.), and the present disclosure should not be limited to what is shown in FIG. 2

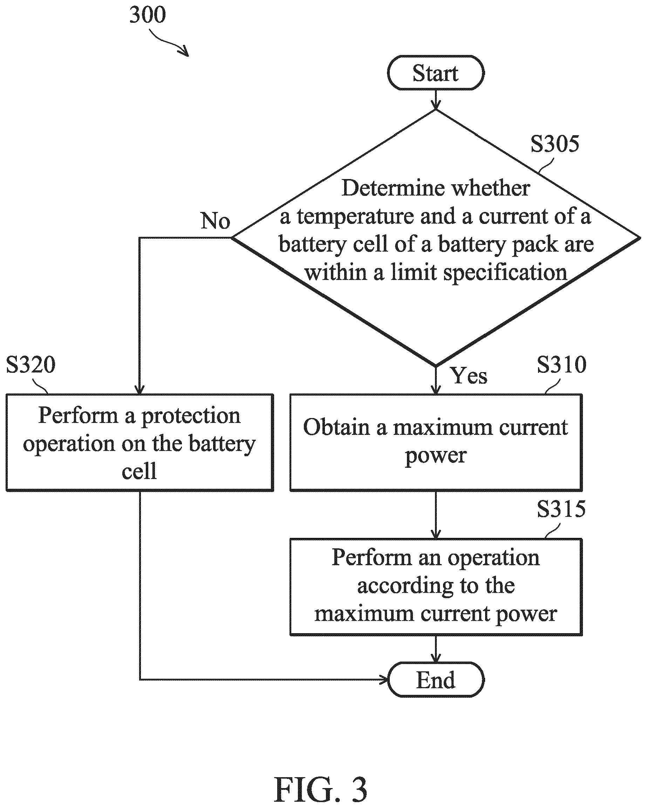

FIG. 3 is a flow chart of a method 300 for artificial intelligence monitoring and protecting battery performance according to an embodiment of the present disclosure. The method 300 is executed by the controller 220 of the battery pack 150 as shown in FIG. 2.

In step S305, the controller determines whether a temperature and a current of a battery cell of a battery pack are within a limit specification. Specifically, the controller may determine whether the temperature of the battery cell is within an operating temperature range, whether the current is within an over-current protection (OCP) operating limit and is within a short-circuit protection operating limit.

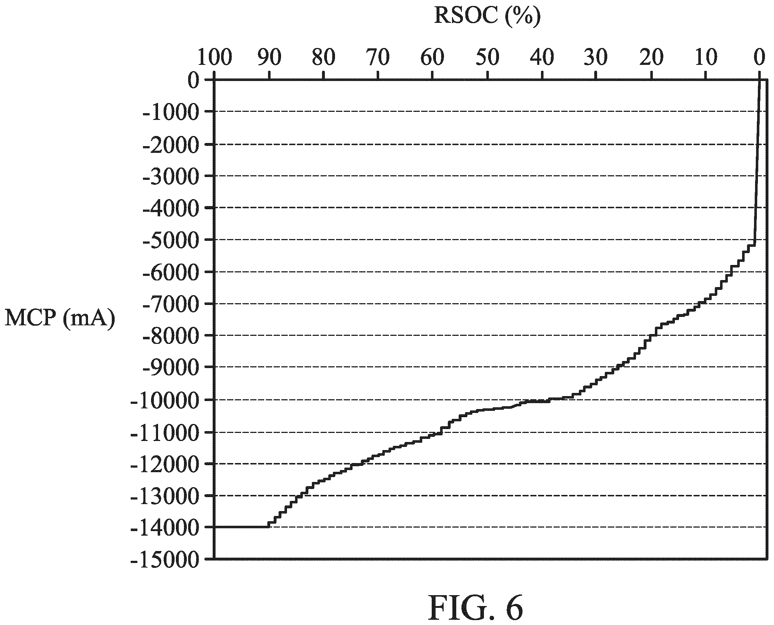

When the temperature and the current of the battery cell are within the limit specification ("Yes" in step S305), in step S310, the controller obtains a maximum current power (MCP), wherein the maximum current power is obtained based on a relative state of charge (RSOC), a voltage, a system impedance value, an optimization parameter, and a battery impedance value of the battery cell. Specifically, the system impedance value is the impedance value of the system 100, and the battery impedance value is the impedance value of the battery cell 210. The optimization parameter is a value generated by the controller using a large language model or a big data model, wherein the value is mainly used to make the relationship between the maximum current power and the RSOC close to a preset curve. For example, the optimization parameter may make the relationship between maximum current power and RSOC close to a 45-degree curve, as shown in FIG. 6. The maximum current power can be expressed by the following formula:

$$MCP = \frac{D}{(E + F + G)} \times B$$

wherein $B$ is the RSOC, $D$ is the voltage, E is the system impedance value, F is the optimization parameter and G is the battery impedance value.

In step S315, the controller performs an operation according to the maximum current power. In one embodiment, the value of the maximum current power may indicate the current power consumption state of the battery pack through a state indicator. The state indicator may be represented by numerical values 0-5, 1-10 or other numerical values. The higher the value, the better the power state that the battery cell can support. The lower the value, the worse the power state that the battery cell can support. For example, the state indicator is represented by numerical values 1-10. The state indicator of 0 means that the power state that the battery cell can support is very low, and the state indicator of 9 or 10 means that the battery cell can support a very good power state and can operate under heavy load.

When the state indicator is lower than a threshold, the controller may send a notification message to a processor or a user to notify the processor of a power condition that the battery cell may currently support. As another example, when the state indicator is lower than a threshold that is 3, the controller can send a notification message to a processor or a user to notify the processor that the power state that the battery cell can currently support is not good. After receiving the notification message, the processor may extend the life of the battery cell by adjusting the load of the battery cell to improve the system's energy efficiency.

Back to step S305, when the temperature and current of the battery cell are not within the limit specification ("No" in step S305), in step S320, the controller performs a protection operation on the battery cell. For example, when the controller determines that the temperature of the battery cell is not within an operating temperature range or the current has reached one of the over-current protection operating limit and the short-circuit protection operating limit, the controller stops using the battery cell.

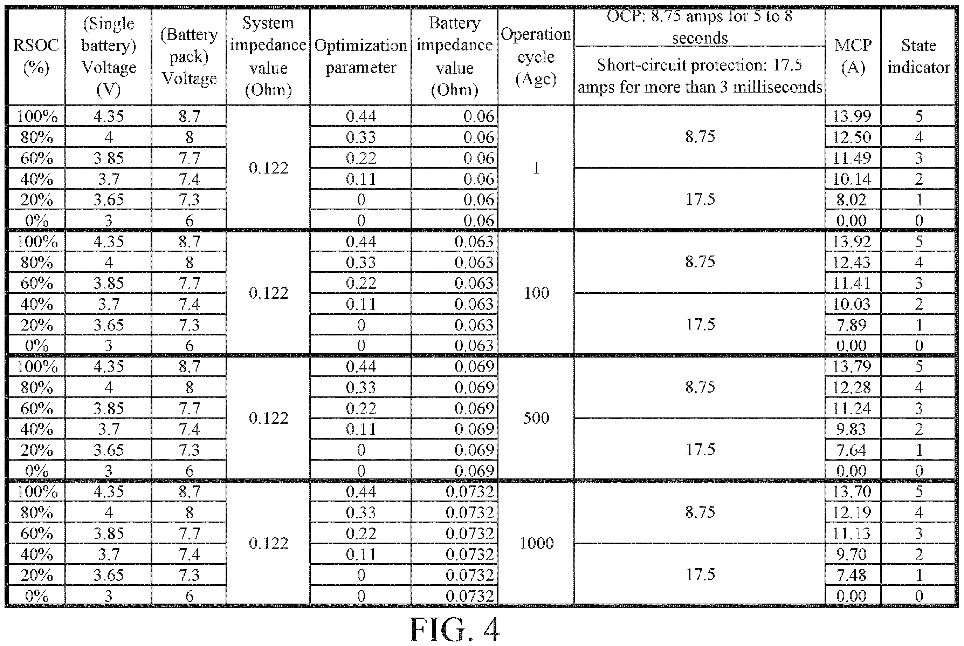

FIG. 4 shows an experimental data table 400 for obtaining the maximum current power and the state indicator according to an embodiment of the present disclosure. In FIG. 4, the battery pack is a combination of two series and one parallel, and the normal current is 3.5 amps. The state indicator is divided into values from 0 to 5 based on the maximum current power.

As shown in the table 400, the battery impedance value is related to the operating cycle. The more operating cycles, the higher the battery impedance value. The maximum current power (MCP) is related to the RSOC, the voltage of the battery pack, the system impedance value, the optimization parameters and the battery impedance value. In other words, the maximum current power is a non-fixed estimated value, which can estimate how much electric energy the battery cell may currently provide, and the maximum current power may change with the number of uses, aging conditions, capacity, etc. of the battery pack.

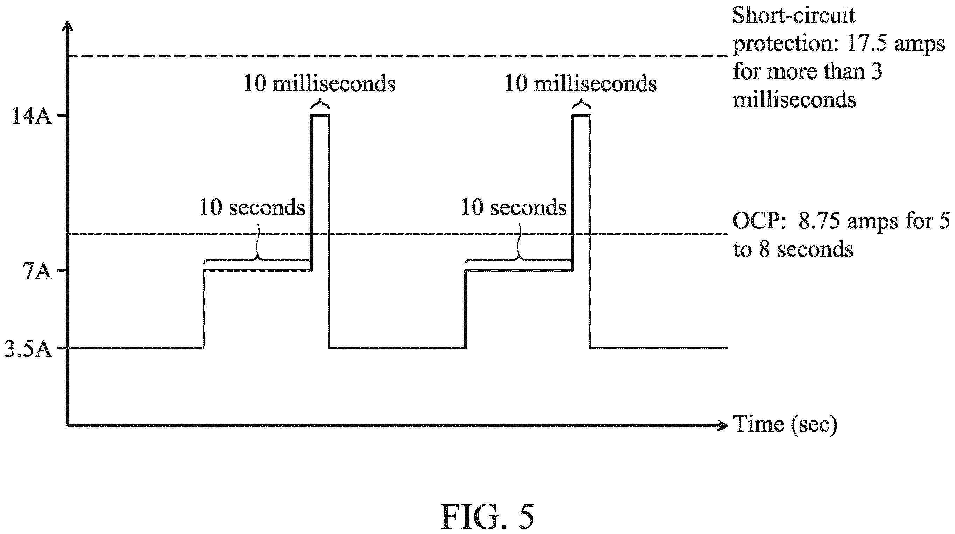

FIG. 5 is a schematic diagram showing the discharge of the battery pack according to an embodiment of the present disclosure with reference to FIG. 4.

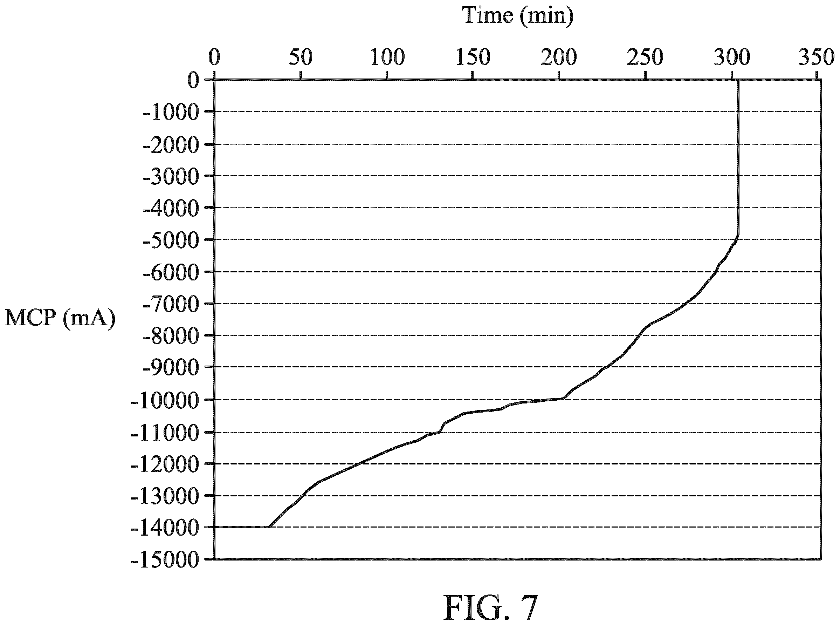

The battery pack operates using a combination of 7 amp current discharge for 10 seconds and 14 amp current discharge for 10 milliseconds. As shown in FIG. 5, the operating current does not exceed the over-current protection (OCP) operating limit (using 8.75 amps and continuing to discharge for 5 to 8 seconds) and the short-circuit protection operating limit (using 17.5 amps of current and continuing to discharge for more than 3 milliseconds). When the battery pack is discharged with this current combination, the relationship between the MCP and the RSOC is shown in FIG. 6, and the relationship between the MCP and the time is shown in FIG. 7. It should be noted that in FIGS. 6 and 7, the MCP is plotted with a negative value (-) indicating discharge.

As shown in FIG. 6, during the discharge process, the operating trend of the MCP conforms to the 45-degree curve and eventually returns to zero in addition to no unexpected peaks. In FIG. 7, the curve of the MCP during the discharge process of the battery pack has no peak and returns to zero after about 300 minutes.

As mentioned above, the method and device for artificial intelligence monitoring and protecting battery performance use the maximum current power to determine the current power state of the battery, which can optimize the interaction between the battery and the load to ensure the stability and efficiency of the battery power supply and improve the energy efficiency of the battery.

The data structures and code described in this detailed description are typically stored on a computer-readable storage medium, which may be any device or medium that can store code and/or data for use by a computer system. The computer-readable storage medium includes, but is not limited to, volatile memory, non-volatile memory, magnetic and optical storage devices such as disk drives, magnetic tape, CDs (compact discs), DVDs (digital versatile discs or digital video discs), or other media capable of storing code and/or data now known or later developed.

The methods and processes described in the detailed description section can be embodied as code and/or data, which can be stored in a computer-readable storage medium as described above. When a computer system reads and executes the code and/or data stored on the computer-readable storage medium, the computer system performs the methods and processes embodied as data structures and code and stored within the computer-readable storage medium.

Furthermore, methods and processes described herein can be included in hardware modules or apparatus. These modules or apparatus may include, but are not limited to, an application-specific integrated circuit (ASIC) chip, a field-programmable gate array (FPGA), a dedicated or shared processor that executes a particular software module or a piece of code at a particular time, and/or other programmable-logic devices now known or later developed. When the hardware modules or apparatus are activated, they perform the methods and processes included within them.

It should be understood that any specific order or hierarchy of steps in any disclosed process is an example of a sample approach. Based upon design preferences, it should be understood that the specific order or hierarchy of steps in the processes may be rearranged while remaining within the scope of the present disclosure. The accompanying method claims present elements of the various steps in a sample order, and are not meant to be limited to the specific order or hierarchy presented.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having the same name (but for use of the ordinal term) to distinguish the claim elements.

While the disclosure has been described by way of example and in terms of the preferred embodiments, it should be understood that the disclosure is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

**Claims**

1.  A method for artificial intelligence monitoring and protecting battery performance, comprising:

    > determining whether a temperature and a current of a battery cell of a battery pack are within a limit specification;
    > obtaining a maximum current power when the temperature and the current of the battery pack are within the limit specification; and
    > performing an operation based on the maximum current power.

2.  The method for artificial intelligence monitoring and protecting battery performance as claimed in claim 1, wherein the maximum current power is obtained based on a relative state of charge, RSOC, a voltage, a system impedance value, an optimization parameter and a battery impedance value of the battery cell.

3.  The method for artificial intelligence monitoring and protecting battery performance as claimed in claim 2, wherein the maximum current power is expressed by the following formula:

$$MCP = \frac{D}{(E + F + G)} \times B$$

wherein $B$ is the RSOC, $D$ is the voltage, $E$ is the system impedance value, F is the optimization parameter and $G$ is the battery impedance value.

4.  The method for artificial intelligence monitoring and protecting battery performance as claimed in claim 2, wherein the optimization parameter is generated by a large language model, LLM, or a large data model.

5.  The method for artificial intelligence monitoring and protecting battery performance as claimed in any of the preceding claims, wherein the step of determining whether the temperature and the current of the battery cell of the battery pack are within the limit specification further comprises:
    determining whether the temperature of the battery cell is within an operating temperature range, whether the current is within an over-current protection, OCP, operating limit and is within a short-circuit protection operating limit.

6.  The method for artificial intelligence monitoring and protecting battery performance as claimed in any of the preceding claims, wherein the step of performing the operation based on the maximum current power further comprises:
    transmitting a notification message to a processor to notify the processor of a power condition that the battery cell currently supports when an indicator corresponding to the maximum current power is lower than a threshold.

7.  The method for artificial intelligence monitoring and protecting battery performance as claimed in any of the preceding claims, wherein the step of performing the operation based on the maximum current power further comprises:
    transmitting a notification message to a processor to notify the processor of a power condition that the battery cell currently supports when an indicator corresponding to the maximum current power is lower than a threshold.

8.  A device for artificial intelligence monitoring and protecting battery performance, comprising:

a battery pack, comprising:

a battery cell; and
a controller;

wherein the controller is operative to:

determine whether a temperature and a current of a battery cell of a battery pack are within a limit specification;
obtain a maximum current power when the temperature and the current of the battery pack are within the limit specification; and
perform an operation based on the maximum current power.

9. The device for artificial intelligence monitoring and protecting battery performance as claimed in claim 8, wherein the maximum current power is obtained based on a relative state of charge, RSOC, a voltage, a system impedance value, an optimization parameter and a battery impedance value of the battery cell.

10. The device for artificial intelligence monitoring and protecting battery performance as claimed in claim 9, wherein the maximum current power is expressed by the following formula:

$$MCP = \frac{D}{(E + F + G)} \times B$$

wherein $B$ is the RSOC, $D$ is the voltage, $E$ is the system impedance value, $F$ is the optimization parameter and $G$ is the battery impedance value.

FIG. 1

FIG. 2

300

Start

S305

Determine whether
a temperature and a current of a
battery cell of a battery pack are
within a limit specification

No

Yes

S310

S320

Perform a protection
operation on the battery
cell

Obtain a maximum current
power

S315

Perform an operation
according to the
maximum current power

End

FIG. 3

| RSOC (%) | (Single battery) Voltage (V) | (Battery pack) Voltage | System impedance value (Ohm) | Optimization parameter | Battery impedance value (Ohm) | Operation cycle (Age) | OCP: 8.75 amps for 5 to 8 seconds / Short-circuit protection: 17.5 amps for more than 3 milliseconds | MCP (A) | State indicator |
|---|---|---|---|---|---|---|---|---|---|
| 100% | 4.35 | 8.7 | | 0.44 | 0.06 | | 8.75 | 13.99 | 5 |
| 80% | 4 | 8 | | 0.33 | 0.06 | | 8.75 | 12.50 | 4 |
| 60% | 3.85 | 7.7 | 0.122 | 0.22 | 0.06 | 1 | | 11.49 | 3 |
| 40% | 3.7 | 7.4 | | 0.11 | 0.06 | | | 10.14 | 2 |
| 20% | 3.65 | 7.3 | | 0 | 0.06 | | 17.5 | 8.02 | 1 |
| 0% | 3 | 6 | | 0 | 0.06 | | | 0.00 | 0 |
| 100% | 4.35 | 8.7 | | 0.44 | 0.063 | | 8.75 | 13.92 | 5 |
| 80% | 4 | 8 | | 0.33 | 0.063 | | 8.75 | 12.43 | 4 |
| 60% | 3.85 | 7.7 | 0.122 | 0.22 | 0.063 | 100 | | 11.41 | 3 |
| 40% | 3.7 | 7.4 | | 0.11 | 0.063 | | | 10.03 | 2 |
| 20% | 3.65 | 7.3 | | 0 | 0.063 | | 17.5 | 7.89 | 1 |
| 0% | 3 | 6 | | 0 | 0.063 | | | 0.00 | 0 |
| 100% | 4.35 | 8.7 | | 0.44 | 0.069 | | 8.75 | 13.79 | 5 |
| 80% | 4 | 8 | | 0.33 | 0.069 | | 8.75 | 12.28 | 4 |
| 60% | 3.85 | 7.7 | 0.122 | 0.22 | 0.069 | 500 | | 11.24 | 3 |
| 40% | 3.7 | 7.4 | | 0.11 | 0.069 | | | 9.83 | 2 |
| 20% | 3.65 | 7.3 | | 0 | 0.069 | | 17.5 | 7.64 | 1 |
| 0% | 3 | 6 | | 0 | 0.069 | | | 0.00 | 0 |
| 100% | 4.35 | 8.7 | | 0.44 | 0.0732 | | 8.75 | 13.70 | 5 |
| 80% | 4 | 8 | | 0.33 | 0.0732 | | 8.75 | 12.19 | 4 |
| 60% | 3.85 | 7.7 | 0.122 | 0.22 | 0.0732 | 1000 | | 11.13 | 3 |
| 40% | 3.7 | 7.4 | | 0.11 | 0.0732 | | | 9.70 | 2 |
| 20% | 3.65 | 7.3 | | 0 | 0.0732 | | 17.5 | 7.48 | 1 |
| 0% | 3 | 6 | | 0 | 0.0732 | | | 0.00 | 0 |

FIG. 4

FIG. 5

FIG. 6

FIG. 7

Europäisches
Patentamt

European
Patent Office

Office européen
des brevets

## EUROPEAN SEARCH REPORT

**Application Number**

EP 24 18 0340

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 668 461 A (HANCOCK KEITH ALAN [US] ET AL) 16 September 1997 (1997-09-16) | 1-3,5-10 | INV. H02J7/00 |
| Y | * column 5, line 50 - column 9, line 18; figure 2 * | 4 | |
| X | EP 3 866 299 A1 (BEIJING XIAOMI MOBILE SOFTWARE CO LTD [CN]) 18 August 2021 (2021-08-18) * paragraphs [0051] - [0079]; figures 9,10 * | 1,8 | |
| Y | US 2019/033385 A1 (KARNER DON [US] ET AL) 31 January 2019 (2019-01-31) | 4 | |
| A | * paragraph [0094] * | 1,8 | |

**TECHNICAL FIELDS SEARCHED (IPC)**

H02J

The present search report has been drawn up for all claims

| Place of search | Date of completion of the search | Examiner |
|---|---|---|
| Munich | 27 November 2024 | Bergler, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 0340

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2024

| Patent document cited in search report | | Publication date | Patent family member(s) | | Publication date |
|---|---|---|---|---|---|
| US 5668461 | A | 16-09-1997 | AU | 1859997 A | 02-09-1997 |
| | | | US | 5668461 A | 16-09-1997 |
| | | | WO | 9730502 A1 | 21-08-1997 |
| EP 3866299 | A1 | 18-08-2021 | CN | 113254300 A | 13-08-2021 |
| | | | EP | 3866299 A1 | 18-08-2021 |
| | | | US | 2021247244 A1 | 12-08-2021 |
| US 2019033385 | A1 | 31-01-2019 | CA | 3070566 A1 | 31-01-2019 |
| | | | CA | 3071116 A1 | 31-01-2019 |
| | | | CA | 3071118 A1 | 31-01-2019 |
| | | | CA | 3071121 A1 | 31-01-2019 |
| | | | CA | 3071122 A1 | 31-01-2019 |
| | | | CA | 3071124 A1 | 31-01-2019 |
| | | | CA | 3071126 A1 | 31-01-2019 |
| | | | CA | 3071141 A1 | 31-01-2019 |
| | | | CA | 3071146 A1 | 31-01-2019 |
| | | | CA | 3071151 A1 | 31-01-2019 |
| | | | CA | 3071154 A1 | 31-01-2019 |
| | | | CA | 3071157 A1 | 31-01-2019 |
| | | | CA | 3071666 A1 | 31-01-2019 |
| | | | CN | 111108401 A | 05-05-2020 |
| | | | CN | 111108402 A | 05-05-2020 |
| | | | CN | 111108404 A | 05-05-2020 |
| | | | CN | 111133325 A | 08-05-2020 |
| | | | CN | 111149007 A | 12-05-2020 |
| | | | CN | 111149008 A | 12-05-2020 |
| | | | CN | 111149009 A | 12-05-2020 |
| | | | CN | 111149010 A | 12-05-2020 |
| | | | CN | 111164435 A | 15-05-2020 |
| | | | CN | 111164439 A | 15-05-2020 |
| | | | CN | 111164440 A | 15-05-2020 |
| | | | CN | 111164441 A | 15-05-2020 |
| | | | CN | 111164821 A | 15-05-2020 |
| | | | CN | 111183461 A | 19-05-2020 |
| | | | EP | 3658932 A1 | 03-06-2020 |
| | | | EP | 3658933 A1 | 03-06-2020 |
| | | | EP | 3658934 A1 | 03-06-2020 |
| | | | EP | 3658935 A2 | 03-06-2020 |
| | | | EP | 3658936 A1 | 03-06-2020 |
| | | | EP | 3658937 A1 | 03-06-2020 |
| | | | EP | 3658938 A2 | 03-06-2020 |
| | | | EP | 3658939 A1 | 03-06-2020 |
| | | | EP | 3658940 A1 | 03-06-2020 |
| | | | EP | 3658941 A1 | 03-06-2020 |
| | | | EP | 3658942 A2 | 03-06-2020 |

EPO FORM P0459

For more details about this annex : see Official Journal of the European Patent Office, No. 12/82

page 1 of 3

## ANNEX TO THE EUROPEAN SEARCH REPORT
## ON EUROPEAN PATENT APPLICATION NO.

EP 24 18 0340

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2024

| Patent document cited in search report | Publication date | Patent family member(s) | | Publication date |
|---|---|---|---|---|
| | | EP | 3658943 A1 | 03-06-2020 |
| | | EP | 3659129 A1 | 03-06-2020 |
| | | EP | 3659203 A1 | 03-06-2020 |
| | | ES | 2924278 T3 | 05-10-2022 |
| | | ES | 2929534 T3 | 30-11-2022 |
| | | ES | 2970610 T3 | 29-05-2024 |
| | | ES | 2987535 T3 | 15-11-2024 |
| | | JP | 2020528981 A | 01-10-2020 |
| | | JP | 2020529020 A | 01-10-2020 |
| | | JP | 2020529021 A | 01-10-2020 |
| | | JP | 2020529022 A | 01-10-2020 |
| | | JP | 2020529024 A | 01-10-2020 |
| | | JP | 2020529107 A | 01-10-2020 |
| | | JP | 2020529108 A | 01-10-2020 |
| | | JP | 2020529109 A | 01-10-2020 |
| | | JP | 2020529110 A | 01-10-2020 |
| | | JP | 2020529111 A | 01-10-2020 |
| | | JP | 2020529112 A | 01-10-2020 |
| | | JP | 2020529114 A | 01-10-2020 |
| | | JP | 2020529662 A | 08-10-2020 |
| | | JP | 2020529663 A | 08-10-2020 |
| | | KR | 20200024332 A | 06-03-2020 |
| | | KR | 20200024358 A | 06-03-2020 |
| | | KR | 20200024359 A | 06-03-2020 |
| | | KR | 20200024944 A | 09-03-2020 |
| | | KR | 20200027039 A | 11-03-2020 |
| | | KR | 20200036893 A | 07-04-2020 |
| | | KR | 20200038264 A | 10-04-2020 |
| | | KR | 20200038265 A | 10-04-2020 |
| | | KR | 20200038267 A | 10-04-2020 |
| | | KR | 20200038269 A | 10-04-2020 |
| | | KR | 20200049770 A | 08-05-2020 |
| | | KR | 20200049771 A | 08-05-2020 |
| | | KR | 20200049772 A | 08-05-2020 |
| | | KR | 20200050455 A | 11-05-2020 |
| | | US | 2019033377 A1 | 31-01-2019 |
| | | US | 2019033381 A1 | 31-01-2019 |
| | | US | 2019033382 A1 | 31-01-2019 |
| | | US | 2019033383 A1 | 31-01-2019 |
| | | US | 2019033384 A1 | 31-01-2019 |
| | | US | 2019033385 A1 | 31-01-2019 |
| | | US | 2019033388 A1 | 31-01-2019 |
| | | US | 2019033393 A1 | 31-01-2019 |
| | | US | 2019033394 A1 | 31-01-2019 |
| | | US | 2019033395 A1 | 31-01-2019 |
| | | US | 2019033396 A1 | 31-01-2019 |

EPO FORM P0459

For more details about this annex : see Official Journal of the European Patent Office, No. 12/82

page 2 of 3

**ANNEX TO THE EUROPEAN SEARCH REPORT
ON EUROPEAN PATENT APPLICATION NO.**                    EP 24 18 0340

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2024

| Patent document cited in search report | Publication date | Patent family member(s) | Publication date |
|---|---|---|---|
| | | US 2019033397 A1 | 31-01-2019 |
| | | US 2019035237 A1 | 31-01-2019 |
| | | US 2019036178 A1 | 31-01-2019 |
| | | US 2022404426 A1 | 22-12-2022 |
| | | WO 2019023629 A2 | 31-01-2019 |
| | | WO 2019023656 A1 | 31-01-2019 |
| | | WO 2019023663 A1 | 31-01-2019 |
| | | WO 2019023666 A1 | 31-01-2019 |
| | | WO 2019023670 A1 | 31-01-2019 |
| | | WO 2019023671 A1 | 31-01-2019 |
| | | WO 2019023673 A1 | 31-01-2019 |
| | | WO 2019023675 A1 | 31-01-2019 |
| | | WO 2019023678 A1 | 31-01-2019 |
| | | WO 2019023679 A1 | 31-01-2019 |
| | | WO 2019023681 A1 | 31-01-2019 |
| | | WO 2019023682 A2 | 31-01-2019 |
| | | WO 2019023684 A1 | 31-01-2019 |
| | | WO 2019023687 A2 | 31-01-2019 |

EPO FORM P0459

For more details about this annex : see Official Journal of the European Patent Office, No. 12/82

page 3 of 3